# EUROPEAN PATENT APPLICATION

(11) **EP 0 582 052 A1**
(43) Date of publication of application: **09.02.1994**
(21) Application number: 93108235.8
(22) Date of filing: 21.05.1993
(51) Int. Cl.: H01L 23/498, H01L 23/31

(54) **Low profile overmolded semiconductor device and method for making the same**

(30) Priority: 06.08.1992 US 925145
(71) Applicant: MOTOROLA, INC., Schaumburg, IL 60196 (US)
(72) Inventor: Sloan, James W., Austin, Texas 78646 (US)
(74) Representative: Spaulding, Sarah Jane

(57) **Abstract**

A low profile overmolded pad array carrier (48) is manufactured using a new substrate (40) having metal on one side and unplated through-holes. The new substrate eliminates the need for a solder resist layer on either side of the substrate. A semiconductor die (50) is mounted on the top side of the substrate and is wire bonded to metal traces (46) on the substrate. A package body (54) is overmolded on the substrate covering at least the die and wire bonds (52). Solder balls (56) are attached in the through-holes (44), thus being directly connected to the metal traces on the top side of the substrate.

## Description

### Field of the Invention

The present invention relates to semiconductor devices in general, and more specifically to resin overmolded leadless pad array carriers and methods for making the same.

### Background of the Invention

Traditional dual-in-line (DIP) packages are commonly used for semiconductor devices with relatively low input/output (I/O) lead counts. However, in packaging devices with high I/O lead counts, DIPs become impractical. Furthermore, the push in the electronics industry is toward surface mount applications whereas DIPs utilize through-hole technology. The development of leadless pad array carriers has provided some advantages over conventional leaded packages, such as DIPs. These leadless pad array carriers allow greater I/O densities without undue size increases. Additionally, the leadless pad array carriers are surface mount packages which are desirable in today's applications.

The general construction of a leadless pad array carrier includes a semiconductor die mounted on an upper surface of a substrate and a plurality of solder balls attached to a lower surface of the substrate. The existing substrate is a printed circuit (PC) board material, such as bismaleimide-triazine (BT) resin, cladded with copper on both upper and lower surfaces. A complicated manufacturing process is involved to produce the final substrate on which the semiconductor die is mounted. The substrate is processed in panel form and then cut into strips for device assembly.

Starting with an entire panel of copper clad PC board material, through-holes or vias and other necessary holes such as tooling holes are drilled into the panel. Then copper is plated onto the copper cladding and to the sidewalls of the through-holes. The copper plating is achieved by using an electroless plating process followed by an electrolytic plating process. It is necessary to plate the through-holes because they provide the conductive paths between the metal on the upper and lower surfaces of the substrate. A metal patterning process is performed next, wherein the copper is photo-etched to define the individual patterns of conductive metal traces on both upper and lower surfaces of the panel.

A pattern of conductive traces for an individual semiconductor die includes bonding posts, routing traces, edge traces, solder pads, and plated through-holes. The bonding posts include the portion of conductive traces that are proximal to the die mounting area and are used in the wire bonding connections between a semiconductor die and the substrate. The edge traces include the portion of the conductive traces that are distal to the die mounting area; or in other words, they are the traces that are located at the edge of the substrate once cut from the panel. Edge traces are necessary to route all traces to ground busses located outside of package outlines. This is done to provide common connections for electro-plating. Edge traces may be used for probing of assembled devices. Edge traces, however, are not necessarily exposed and may remain covered by solder resist on some devices. Solder pads include the portion of conductive traces located on the lower surface of the substrate where the traces terminate. Solder pads are used for the connection of solder balls to the substrate to provide external electrical connections to the device. Routing traces are merely those portions of the conductive traces that connect the bonding posts to the edge traces as well as to the solder pads. Electrical continuity is maintained between the traces on the upper and lower surfaces of the substrate through the plated through-holes.

After the photo-etching, a thin film of solder resist is applied over the entire surface area of both upper and lower surfaces of the panel. A resist patterning process is performed next, wherein the solder resist layer is etched away to reveal selective portions of the patterns of conductive metal traces. The portions that are revealed include die mounting areas, the bonding posts, and the edge traces, all of the above being on the upper surface of the panel. Additionally, solder pads on the bottom surface of the panel are also exposed after the patterning of the resist layer. The layer of solder resist serves several purposes. First, the resist prevents solder from running onto the traces during the solder bumping process where solder balls are attached to the solder pads on the lower surface of the substrate. Furthermore, the resist layer provides a uniform and smooth surface for the clamping of the mold die during the molding operation. The exposed portions of the patterns of conductive metal traces are subsequently plated with nickel and gold. The panel is then cut into strips which are then used in the assembly process to manufacture leadless pad array carriers.

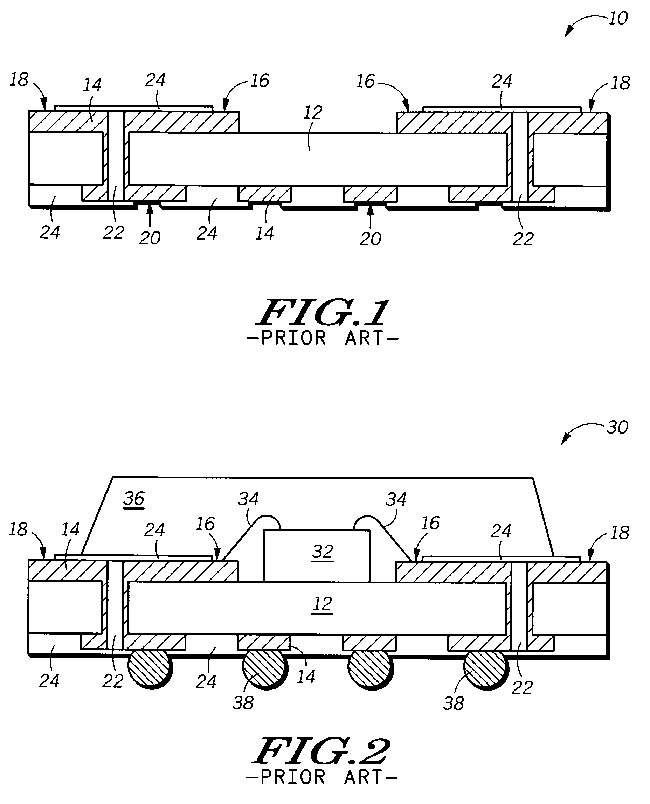

FIG. 1 illustrates, in cross section, a completed substrate 10 for a leadless pad array carrier of the prior art. As illustrated, a PC board material substrate 12 has a pattern of conductive metal traces 14 on both upper and lower surfaces. The pattern of traces 14 has bonding posts 16, edge traces 18, and solder pads 20. Solder pads 20 are all connected to the traces 14 on the upper surface of the substrate, but those connections may not be visible in this cross section plane. Also illustrated are plated through-holes 22. Solder resist 24 is also depicted in FIG. 1, where the solder resist is located on both upper and lower surfaces of the substrate.

FIG. 2 illustrates an assembled leadless pad array carrier 30 of the prior art. As illustrated, a semiconductor die 32 is mounted onto the upper surface of the substrate 10. The die 32 is electrically connected to the bonding posts 16 with a plurality of wires 34 which are bonded to the die 32 and the wire bonding posts 16. The wire bonded semiconductor die is protected with a molded package body 36. Package body 36 is formed by a transfer molding process or a glob top process which overmolds the die 32 and wire bonds 34 with an encapsulating material. After molding, a plurality of solder balls 38 are attached to the solder pads 20 on the bottom surface of the substrate 10. In practice, devices are assembled in strip form and then singulated into individual devices after complete assembly.

One disadvantage to the above described leadless pad array carrier is the complexity of the substrate required. Because the pattern of conductive metal traces are on both the upper and lower surfaces of the substrate, the routing of the traces becomes complicated. Moreover, the capacitance and inductance of the device are directly proportional to the overall length of the traces. Therefore, it is desired to make the traces as short as possible, which is not always possible with complicated routing of traces. It is also desirable to make the leadless pad array carrier as thin as possible because it is targeted for use in portable equipment such as radios and pagers. Any savings in the overall height of the carrier can have significant benefits.

### Summary of the Invention

In accordance with the invention, there is provided a method for manufacturing a semiconductor device having a substrate, a semiconductor die, a package body, and a plurality of solder balls. The substrate has a first surface, a second surface, a plurality of through-holes, and a coefficient of thermal expansion, wherein only the first surface has a pattern of conductive metal traces terminating in a plurality of solder pads over the plurality of through-holes. The semiconductor die is mounted on the first surface and is electrically connected to the pattern of conductive metal traces. The package body, formed by an encapsulating material having a coefficient of thermal expansion, covers at least the semiconductor die. The plurality of solder balls is attached to the plurality of solder pads on the first surface by way of the plurality of through-holes, where the plurality of solder balls extend from the second surface of the substrate.

These and other features, and advantages, will be more clearly understood from the following detailed description taken in conjunction with the accompanying drawings. It is important to point out that the illustrations may not necessarily be drawn to scale, and that there may be other embodiments of the present invention which are not specifically illustrated.

### Brief Description of the Drawings

FIG. 1 illustrates, in cross section, a substrate for a pad array carrier of the prior art.

FIG. 2 illustrates, in cross section, a pad array carrier of the prior art constructed on the substrate of FIG. 1.

FIG. 3 illustrates, in a top view, an improved substrate for a low profile overmolded pad array carrier, in accordance with an embodiment of the present invention.

FIGs. 4&5 illustrate, in cross section, process steps for manufacturing a low profile overmolded pad array carrier constructed on the substrate of FIG. 3, in accordance with an embodiment of the present invention.

FIG. 6 illustrates, in cross section, an alternative substrate for a low profile overmolded pad array carrier, in accordance with another embodiment of the present invention.

### Detailed Description of a Preferred Embodiment

The invention will now be discussed with reference to the figures.

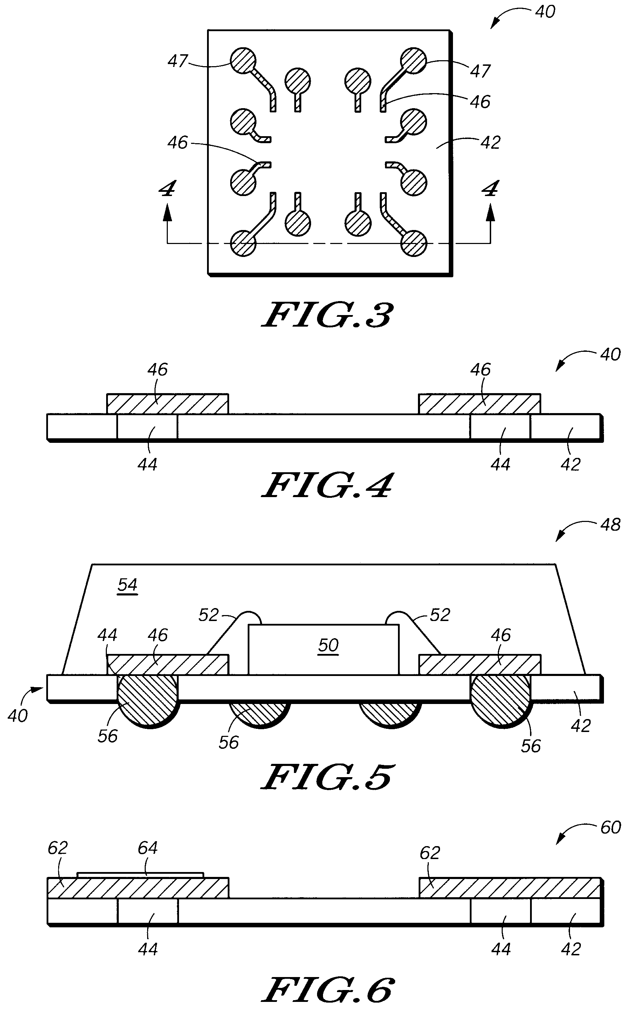

FIG. 3 is a top view illustrating an improved substrate 40 for a low profile overmolded pad array carrier. Improved substrate 40 has thickness substantially in a range of 0.165 millimeter to 0.300 millimeter. Improved substrate 40 is composed of a polymeric material substrate 42 having a pattern of conductive metal traces 46 on an upper surface of substrate 42. The polymeric material substrate 42 can be, but is not limited to, a BT resin cladded with copper, wherein the copper is patterned or etched to form the pattern of conductive metal traces 46. Traces 46 terminate in a plurality of solder pads 47. Improved substrate 40 is processed in a substantially similar manner as the prior art substrate described in reference ot FIG. 1, so the metal traces are actually plated after patterning with other metals such as nickel and gold for improved conductivity and wettability to solder.

FIGs. 4-5 illustrate process steps for manufacturing a low profile overmolded pad array carrier constructed on an improved substrate. Furthermore, FIG. 4 is a cross sectional view along line 4-4 of the substrate 40 of FIG. 3. As illustrated in FIG. 4, an improved substrate 40 for a leadless pad array carrier is provided. Improved substrate 40 has a plurality of through-holes 44 in the polymeric material substrate 42, wherein through-holes 44 open directly to the backside metal of the solder pads illustrated in FIG. 3.

FIG. 5 illustrates, in cross section, a completely assembled low profile overmolded pad array carrier 48. In FIG. 5, a semiconductor die 50 is mounted onto substrate 40. The die 50 is electrically connected to the traces 46 with a plurality of wire bonds 52. After wire bonding, a package body 54 is overmolded on the substrate by means of a transfer molding or glob top process to fully cover the die 50, the wire bonds 52 and the traces 46. Package body 54 can be, but is not limited to, any encapsulating material such as a polymeric resin molding compound. It is desirable that the materials used for package body 54 and the polymer substrate 42 have coefficients of thermal expansion substantially in the same range to minimize potential warpage of the molded device. The overmolding process is performed using conventional transfer molding equipment. After the overmolding of the package body 54, a plurality of solder balls 56 are attached to the substrate to provide external electrical connections for die 50. Solder balls 56 are directly connected to the backside of the traces 46 in the through-holes 44. One advantage of directly attaching the solder balls to the backside of the conductive traces is that the routing of the traces becomes much simpler, plus it is possible to have greater routing density. There is no need to route the traces from the upper surface of the substrate to the lower surface of the substrate. An additional advantage is that the lengths of the conductive paths are shorter as compared to the prior art of FIG. 1 so that the inductance and capacitance of the device are reduced.

This embodiment has several other advantages over the prior art. The substrate has been simplified considerably to include metal on only one surface of the substrate. The metal patterning process is thus reduced to require only metal etching on one surface of the substrate which is both a time and material cost savings. Furthermore, solder resist has been completely eliminated from the substrate which also simplifies the manufacturing of the substrate. The reason that solder resist is not necessary on the lower surface of the substrate is that there is no metallization on this surface. There is no risk of solder running onto the traces and shorting the device during the solder bumping process where solder balls are attached to the traces in the through-holes. Solder resist is not necessary on the upper surface of the substrate. Since electroless plating is used, the device has no edge traces in this embodiment. Therefore, the traces do not extend to the edges of the substrate, thus allowing the mold die to clamp onto a smooth surface at the edges of the substrate. The steps of applying a layer of solder resist on both upper and lower surfaces of the substrate and then patterning the solder resist are eliminated. An added benefit to having metal on only one surface of the substrate and no solder resist is that the thickness of the substrate has been reduced. A thinner substrate translates into a thinner leadless pad array carrier which is desirable, especially in portable equipment applications such as radios and pagers.

Illustrated in FIG. 6 is an alternative embodiment for a leadless pad array carrier substrate 60. As depicted, substrate 60 is composed of a polymeric material substrate 42 having a plurality of through-holes 44. Substrate 60 also has pattern of conductive metal traces 62 on an upper surface, wherein the traces 62 extend to the edges of the substrate. The pattern of conductive metal traces 62 also includes a plurality of solder pads (not illustrated in this view) substantially similar to those illustrated in FIG. 3, wherein through-holes 44 in polymeric material substrate 42 open directly to the backside metal of the solder pads. Having a solder resist layer 64 on the upper surface of the substrate is optional; therefore, the left half of FIG. 6 illustrates the substrate having a solder resist layer, while the right half of FIG. 6 illustrates the substrate without a solder resist layer. The solder resist layer aids the overmolding operation by providing a smooth surface for the clamping of the mold die. Nevertheless, it is possible to design the mold die such that it conforms to the gaps in between the traces so that there is tight seal when the mold die is clamped on the substrate. However, having the solder resist layer in the case of having edge traces leads to an easier molding process.

The foregoing description and illustrations contained herein demonstrate many of the advantages associated with the present invention. In particular, it has been revealed that a leadless pad array carrier can be manufactured using an improved substrate. The substrate has metal on only one surface and does not require a solder resist layer, thus simplifying the processing of the substrate which translates to a cost savings. Moreover, by eliminating metal on one side and the solder resist layers, the thickness of the substrate is reduced giving rise to a lower profile leadless pad array carrier.

Thus it is apparent that there has been provided, in accordance with the invention, a low profile overmolded semiconductor device and method for making the same that fully meet the need and advantages set forth previously. Although the invention has been described and illustrated with reference to specific embodiments thereof, it is not intended that the invention be limited to these illustrative embodiments. Those skilled in the art will recognize that modifications and variations can be made without departing from the spirit of the invention. For example, patterns of conductive metal traces may vary from that illustrated, depending on the specific requirements of the semiconductor device. Furthermore, although the improved substrates do not require that the through-holes be plated, plated through-holes may also be used if needed to facilitate the attachment of the solder balls to the backside metal of the solder pads. Therefore, it is intended that this invention encompass all such variations and modifications as fall within the scope of the appended claims.

## Claims

1. A low profile overmolded semiconductor device (48) comprising:
a substrate (40) having a first surface, a second surface, and a plurality of through-holes (44), only the first surface having a pattern of conductive metal traces (46) which terminates in a plurality of solder pads (47) overlying the plurality of through-holes;
a semiconductor die (50) mounted on the first surface, the semiconductor die electrically connected to the pattern of conductive metal traces;
a package body (54) formed by an encapsulating material covering at least the semiconductor die; and
a plurality of solder balls (56) extending from the second surface wherein the plurality of solder balls are connected to the plurality of solder pads on the first surface by way of the plurality of through-holes.

2. The semiconductor device of claim 1 wherein the encapsulating material forming the package body is a polymeric molding compound.

3. The semiconductor device of claim 1 wherein the plurality of solder balls has an array configuration.

4. The semiconductor device of claim 1 wherein the substrate is composed of a BT resin clad with copper.

5. The semiconductor device of claim 4 wherein the substrate has a thickness substantially in a range of 0.165 millimeter to 0.300 millimeter.

6. The semiconductor device of claim 1 wherein the substrate also has a layer of solder resist (64) on the first surface.

7. The semiconductor device of claim 1 wherein the semiconductor die is electrically connected the pattern of conductive traces by a plurality of wire bonds (52).

8. A method of fabricating a low profile overmolded semiconductor device (40) comprising the steps of:
providing a substrate (40) having a first surface, a second surface, and a plurality of through-holes (44), only the first surface having a pattern of conductive metal traces (46) which terminates in a plurality of solder pads (47) over the plurality of through-holes;
mounting a semiconductor die (50) on the first surface;
electrically connecting the semiconductor die to the pattern of conductive metal traces;
forming a package body (54) with an encapsulating material to cover at least the semiconductor die; and
attaching a plurality of solder balls (56) in the plurality of through-holes to connect the plurality of solder balls to the plurality of solder pads, wherein the plurality of solder balls extend from the second surface of the substrate.

9. The method of claim 8 wherein the step of providing a substrate comprises providing a substrate composed of a BT resin clad with copper.

10. The method of claim 8 wherein the step of electrically connecting the semiconductor die is performed by wire bonding.
